# EUROPEAN PATENT APPLICATION

(11) **EP 4 611 519 A1**
(43) Date of publication of application: **03.09.2025**
(21) Application number: 25157645.0
(22) Date of filing: 13.02.2025
(51) Int. Cl.: H10K 59/80, H10K 50/856, H10K 59/38

(54) **MIRROR ELECTRONIC DEVICE**

(30) Priority: 01.03.2024 US 202463559881 P; 16.10.2024 CN 202411447370
(71) Applicant: InnoLux Corporation, Jhunan Town Miao li 35053 (TW)
(72) Inventor: LO, Wei-Sung, 35053 Jhunan Town, Miaoli County (TW); LIAO, Shih-Fu, 35053 Jhunan Town, Miaoli County (TW); YAO, I-AN, 35053 Jhunan Town, Miaoli County (TW)
(74) Representative: Becker, Eberhard

(57) **Abstract**

A mirror electronic device includes a first substrate (SB1), a circuit layer (CL), multiple electronic units (EU), a second substrate (SB2), a reflective layer (100), and a first light absorbing layer (200). The circuit layer is disposed on the first substrate. The electronic units are disposed on the first substrate and are electrically connected to the circuit layer. The second substrate includes a light-transmitting region (R1) and a light-reflecting region (R2). The light-transmitting region is adjacent to the light-reflecting region and overlaps the electronic units. The reflective layer is disposed on the second substrate adjacent to the first substrate and located in the light-reflecting region. The first light absorbing layer is disposed on the reflective layer away from the second substrate. A width of the first light absorbing layer is less than or equal to a width of the reflective layer, and is greater than or equal to 50% of the width of the reflective layer.

## Description

### BACKGROUND

### Technical Field

The disclosure relates to a mirror electronic device, and more particularly, to a mirror electronic device used in an electronic device.

### Description of Related Art

In a mirror electronic device in the conventional technology, in order to improve reflectivity when it is not in a turned-on state, a multi-layer film with high reflectivity is attached to an outer surface of a substrate of the mirror electronic device to increase the reflectivity of the mirror electronic device. However, the configuration of the above multi-layer film with high reflectivity will affect light emitted by an electronic unit in the mirror electronic device, so that the mirror electronic device in the conventional technology will have relatively poor light emitting efficiency and display relatively poor image quality.

### SUMMARY

The disclosure provides a mirror electronic device, which may improve image e quality for display.

A mirror electronic device in the disclosure includes a first substrate, a circuit layer, multiple electronic units, a second substrate, a reflective layer, a first light-absorbing layer, and an adhesive layer. The circuit layer is disposed on the first substrate. The electronic units are disposed on the first substrate, and are electrically connected to the circuit layer. The second substrate is opposite to the first substrate, and includes a light-transmitting region and a light-reflecting region. The light-transmitting region is adjacent to the light-reflecting region, and the light-transmitting region overlaps the electronic units. The reflective layer is disposed on a side of the second substrate adjacent to the first substrate, and is located in the light-reflecting region. The first light-absorbing layer is disposed on a side of the reflective layer away from the second substrate. The adhesive layer is disposed between the first light-absorbing layer and the electronic units. In a cross-sectional view of the mirror electronic device, a width of the first light-absorbing layer is less than or equal to a width of the reflective layer, and the width of the first light-absorbing layer is greater than or equal to 50% of the width of the reflective layer.

Based on the above, the mirror electronic device provided in the disclosure defines the light-transmitting region and the light-reflecting region through the configuration of the reflective layer. Through the above design, the configuration of the reflective layer may reduce a possibility of affecting light emitted by the electronic units in the mirror electronic device, thereby increasing light emitting efficiency of the mirror electronic device when it is in a turned-on state to improve quality of a display image thereof.

In order for the aforementioned features and advantages of the disclosure to be more comprehensible, embodiments accompanied with drawings are described in detail below.

### BRIEF DESCRIPTION OF THE DRAWINGS

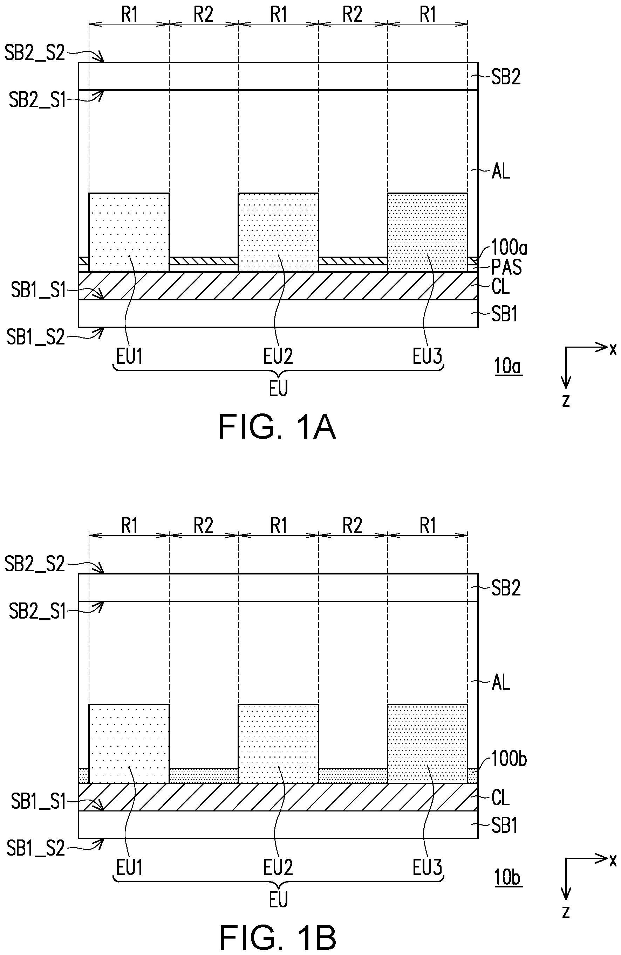

FIG. 1A is a schematic partial cross-sectional view of a mirror electronic device according to the first embodiment of the disclosure.
FIG. 1B is a schematic partial cross-sectional view of a mirror electronic device according to the second embodiment of the disclosure.

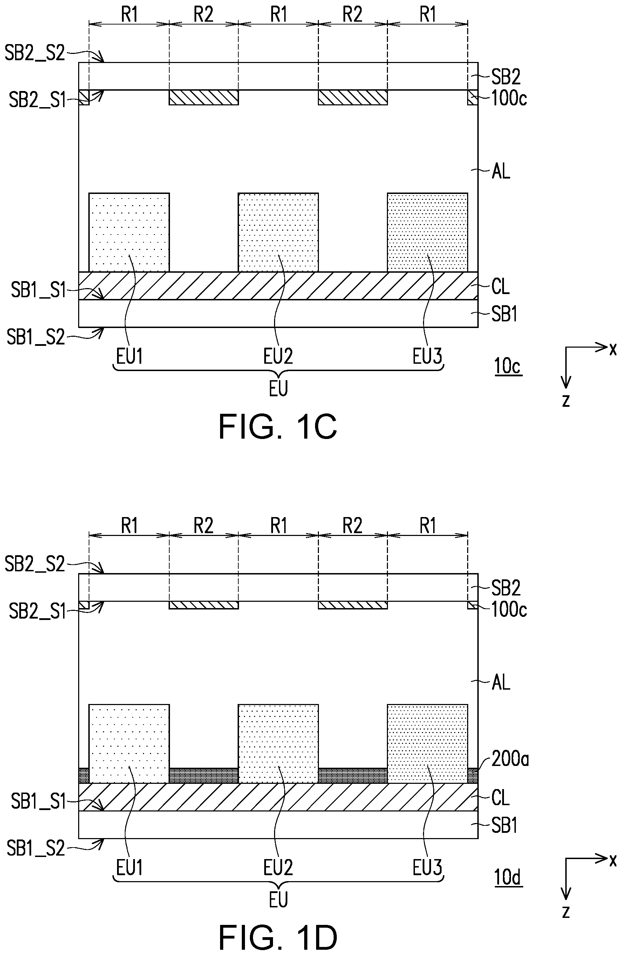

FIG. 1C is a schematic partial cross-sectional view of a mirror electronic device according to the third embodiment of the disclosure.
FIG. 1D is a schematic partial cross-sectional view of a mirror electronic device according to the fourth embodiment of the disclosure.

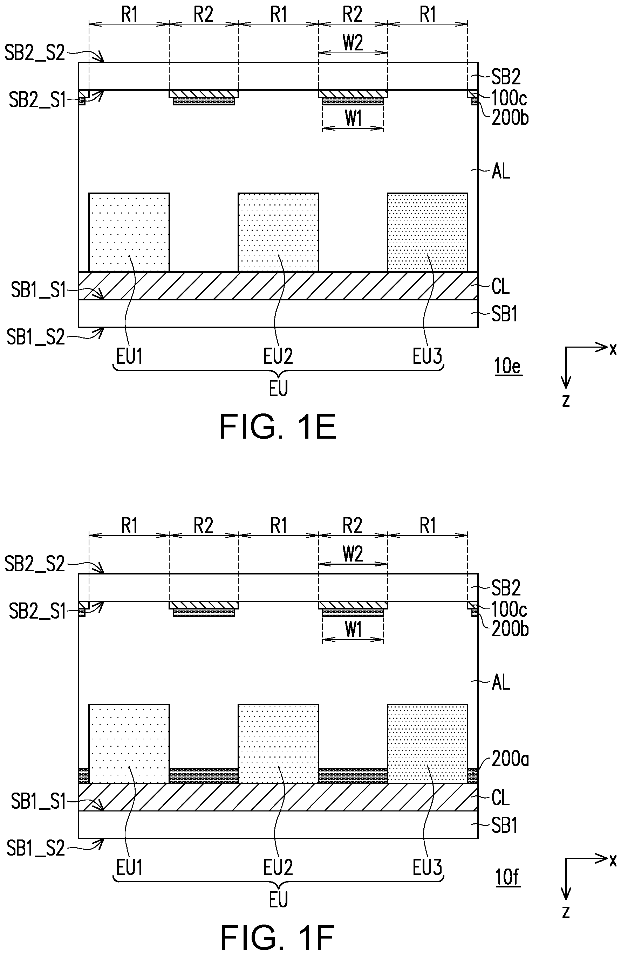

FIG. 1E is a schematic partial cross-sectional view of a mirror electronic device according to the fifth embodiment of the disclosure.
FIG. 1F is a schematic partial cross-sectional view of a mirror electronic device according to the sixth embodiment of the disclosure.

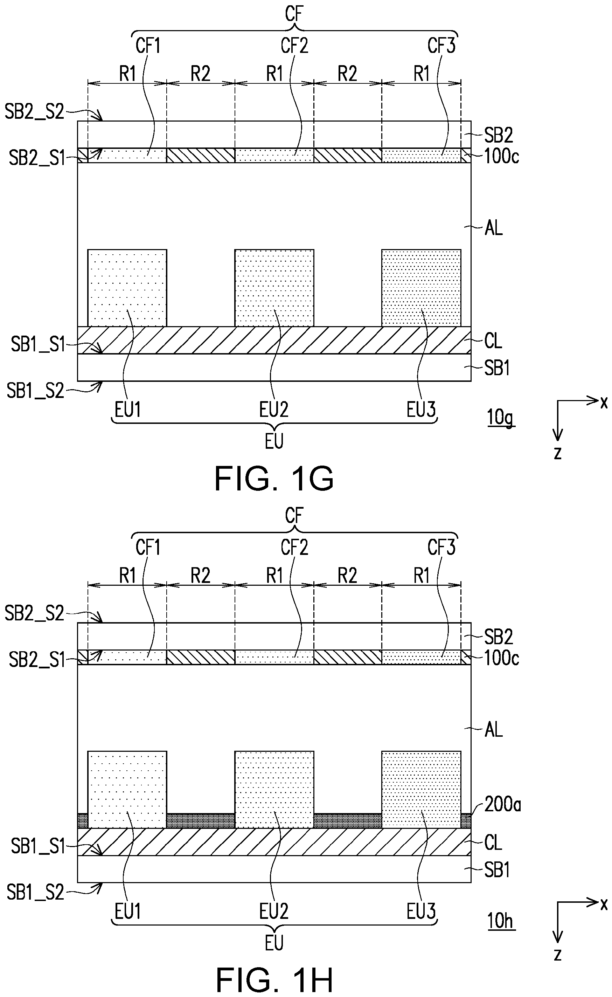

FIG. 1G is a schematic partial cross-sectional view of a mirror electronic device according to the seventh embodiment of the disclosure.
FIG. 1H is a schematic partial cross-sectional view of a mirror electronic device according to the eighth embodiment of the disclosure.

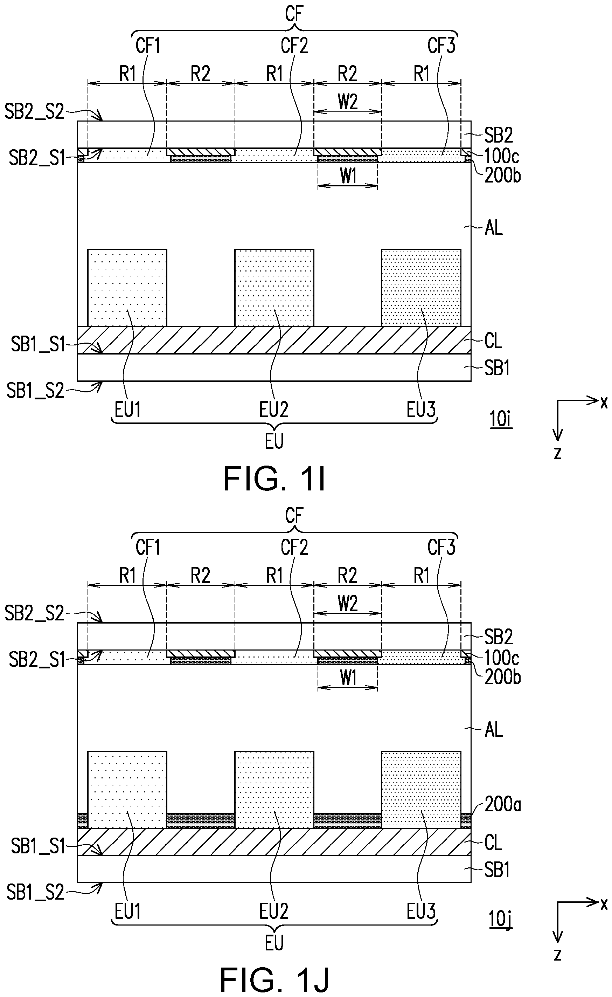

FIG. 1I is a schematic partial cross-sectional view of a mirror electronic device according to the ninth embodiment of the disclosure.
FIG. 1J is a schematic partial cross-sectional view of a mirror electronic device according to the tenth embodiment of the disclosure.

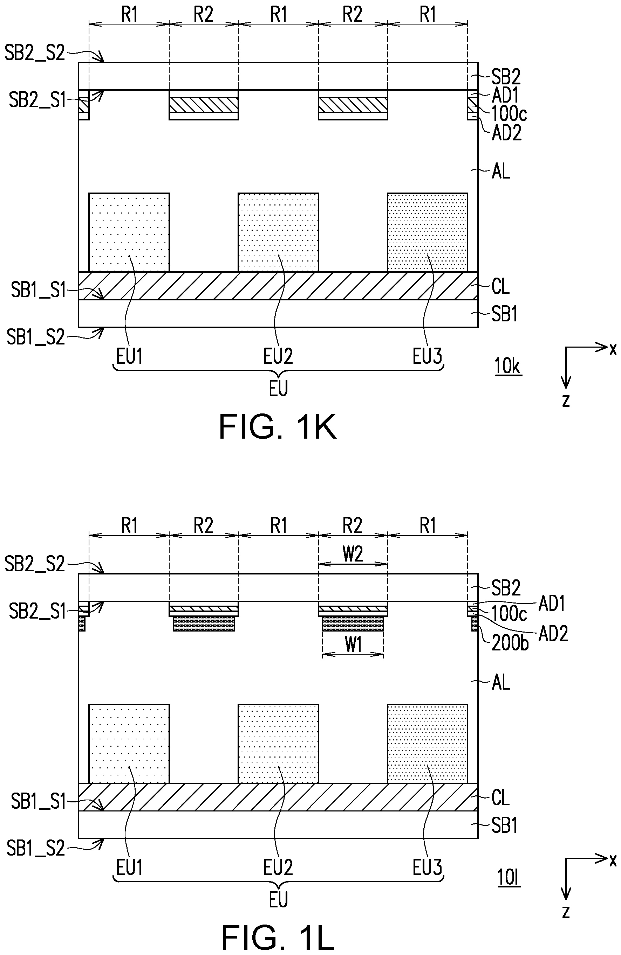

FIG. 1K is a schematic partial cross-sectional view of a mirror electronic device according to the eleventh embodiment of the disclosure.
FIG. 1L is a schematic partial cross-sectional view of a mirror electronic device according to the twelfth embodiment of the disclosure.

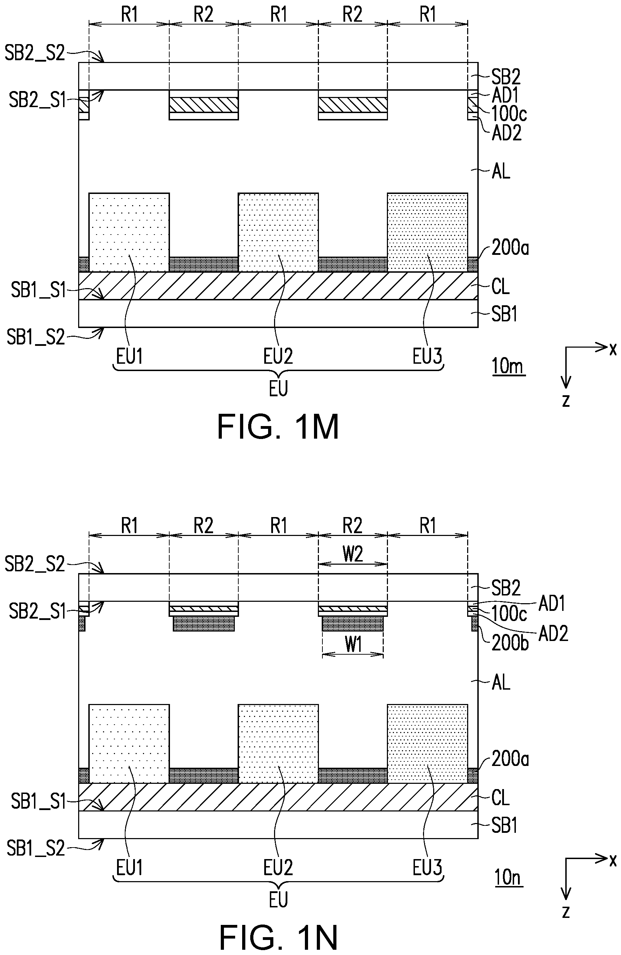

FIG. 1M is a schematic partial cross-sectional view of a mirror electronic device according to the thirteenth embodiment of the disclosure.
FIG. 1N is a schematic partial cross-sectional view of a mirror electronic device according to the fourteenth embodiment of the disclosure.

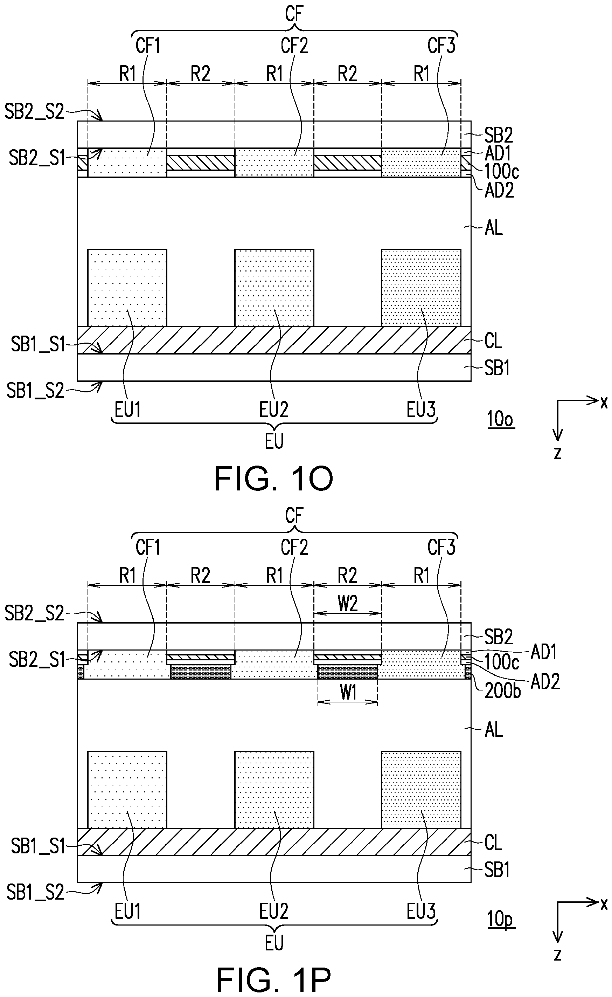

FIG. 1O is a schematic partial cross-sectional view of a mirror electronic device according to the fifteenth embodiment of the disclosure.
FIG. 1P is a schematic partial cross-sectional view of a mirror electronic device according to the sixteenth embodiment of the disclosure.

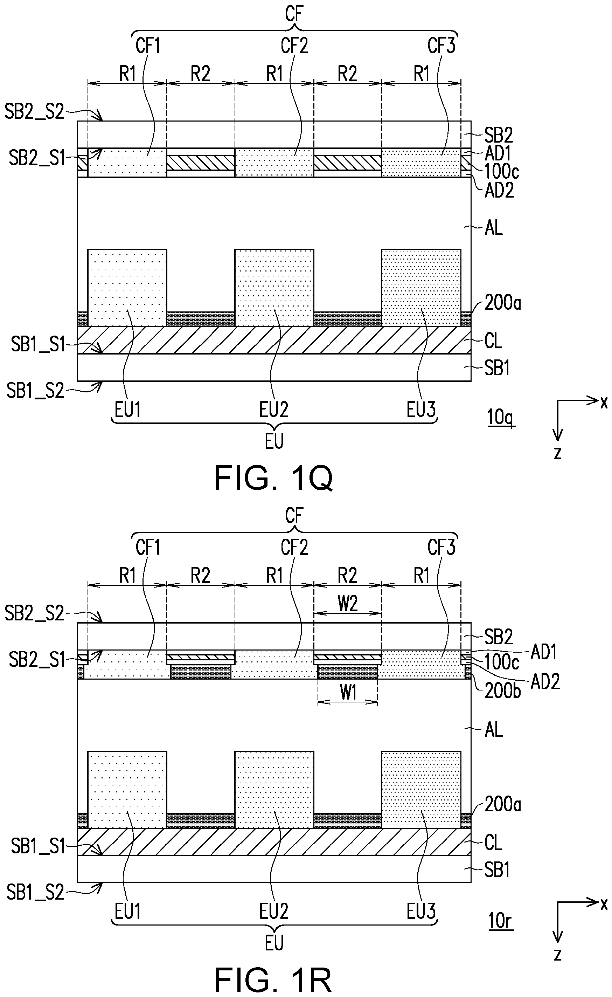

FIG. 1Q is a schematic partial cross-sectional view of a mirror electronic device according to the seventeenth embodiment of the disclosure.
FIG. 1R is a schematic partial cross-sectional view of a mirror electronic device according to the eighteenth embodiment of the disclosure.

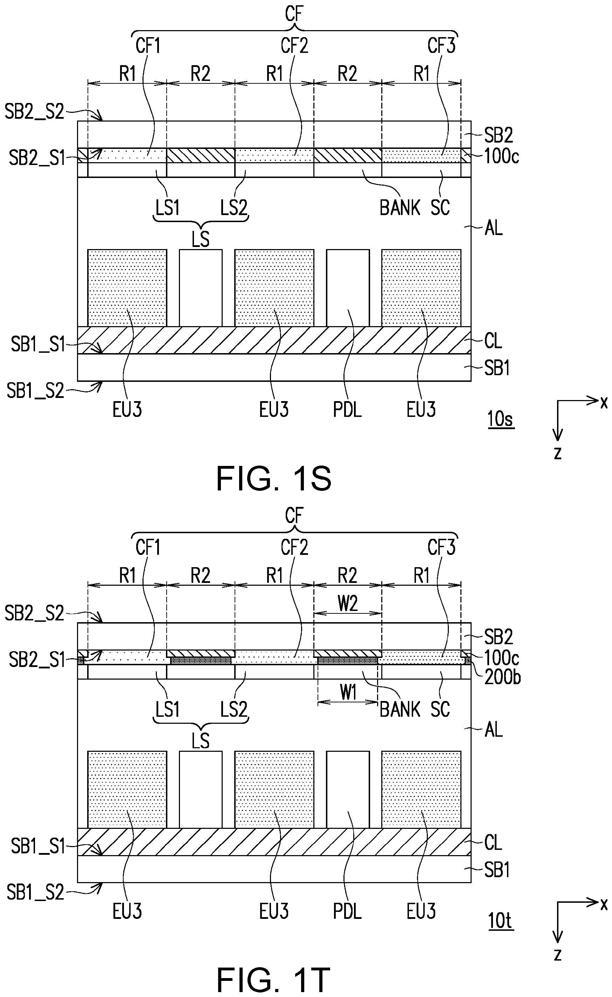

FIG. 1S is a schematic partial cross-sectional view of a mirror electronic device according to the nineteenth embodiment of the disclosure.
FIG. 1T is a schematic partial cross-sectional view of a mirror electronic device according to the twentieth embodiment of the disclosure.

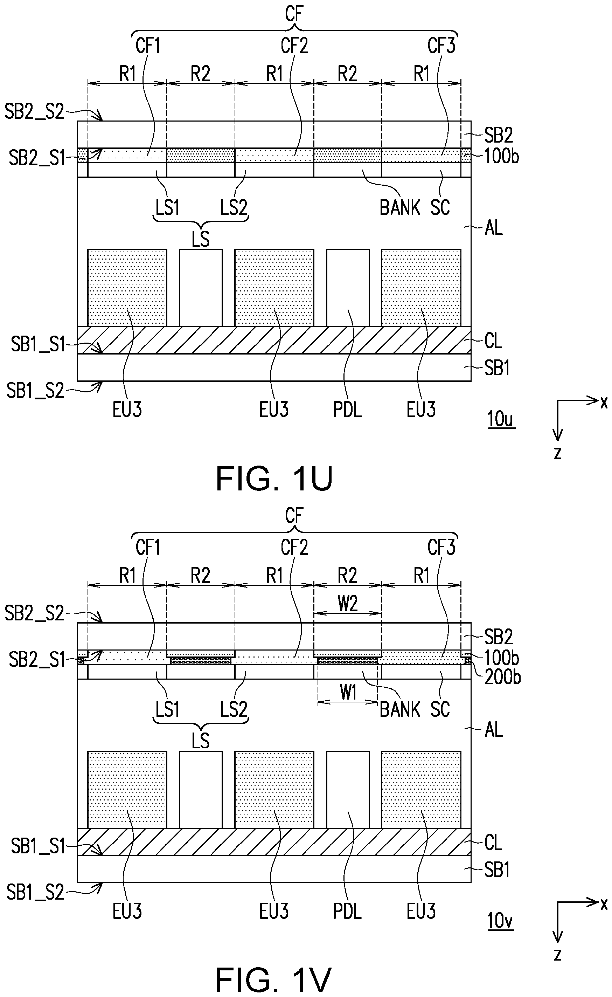

FIG. 1U is a schematic partial cross-sectional view of a mirror electronic device according to the twenty-first embodiment of the disclosure.
FIG. 1V is a schematic partial cross-sectional view of a mirror electronic device according to the twenty-second embodiment of the disclosure.

### DETAILED DESCRIPTION OF DISCLOSED EMBODIMENTS

Reference will now be made in detail to the exemplary embodiments of the disclosure, and examples of the exemplary embodiments are illustrated in the accompanying drawings. Whenever possible, the same reference numerals are used in the drawings and descriptions to indicate the same or similar parts.

The disclosure can be understood by referring to the following detailed description in combination with the accompanying drawings. It should be noted that in order to make it easy for the reader to understand and for the simplicity of the drawings, the multiple drawings in this disclosure only depict a part of the electronic device, and the specific components in the drawings are not drawn according to actual scale. In addition, the number and size of each component in the drawings are only for exemplary purpose, and are not intended to limit the scope of the disclosure.

Throughout the disclosure and the appended claims, certain words are used to refer to specific components. Those skilled in the art should understand that electronic device manufacturers may refer to the same components by different names. The disclosure does not intend to distinguish those components with the same function but different names. In the following description and claims, the terms "including," "containing," and "having" are open-ended terms, so they should be interpreted as "include but not limited to...". Therefore, when the terms "including," "containing," and/or "having" are used in the description of this disclosure, they specify the existence of a corresponding feature, region, step, operation, and/or component, but do not exclude the existence of one or more corresponding features, regions, steps, operations, and/or components.

Direction terms mentioned in this specification, such as such as "up," "down," "front," "back," "left," and "right," merely refer to directions in the accompanying drawings. Therefore, the direction terms used is for illustration, not for limiting this disclosure. In the drawings, each drawing shows the general features of the method, structure, and/or material used in a specific embodiment. However, these drawings should not be construed as defining or limiting the scope or nature of the embodiments. For example, for the sake of clarity, the relative size, thickness, and position of each layer, region, and/or structure may be reduced or enlarged.

When a corresponding member (such as a layer or a region) is described as being "on another member," it may be directly disposed or formed on another member, or there may be other member therebetween. On the other hand, when a member is described as being "directly on another member," no member exists therebetween. In addition, when a member is described as being "on another member," the two have a vertical relationship in the top view direction, and this member may be located above or below the other member, and the vertical relationship depends on the device orientation.

The terms "equal to" or "same" and "essentially" or "substantially" are generally interpreted as within 20% of a given value or range, or as within 10%, 5%, 3%, 2%, 1%, or 0.5% of the value or range.

Ordinal numbers in this specification and the claims such as "first" and "second" are used to modify a component, and do not imply or represent that the (or these) component(s) has (or have) any ordinal number, and do not indicate any order between a component and another component, or an order in a manufacturing method. These ordinal numbers are merely used to clearly distinguish a component having a name with another component having the same name. Different terms may be used in the claims and the specification, so that a first member in the specification may be a second member in the claims.

It should be understood that the following embodiments may disassemble, replace, reorganize, and mix the features in several different embodiments to complete other embodiments without departing from the spirit of the disclosure. As long as the features of the embodiments do not violate the spirit of the disclosure or conflict each other, they may be mixed and matched as desired.

Electrical connection or electric connection described in the disclosure may refer to direct connection or indirect connection. In a case of the direct connection, end points of the components on the two circuits are directly connected or connected to each other with a conductor line, while in a case of the indirect connection, there are switches, diodes, capacitors, inductors, other suitable components, or a combination of the above components between the end points of the components on the two circuits. However, the disclosure is not limited thereto.

In the disclosure, a thickness, a length, a width, and an area may be measured using an optical microscope, and the thickness may be measured using a cross-sectional image in an electron microscope. However, the disclosure is not limited thereto. In addition, any two values or directions used for comparison may have certain errors. If a first value is equal to a second value, it implies that there may be an error of about 10% between the first value and the second value. If a first direction is perpendicular to a second direction, an angle between the first direction and the second direction may be between 80 degrees and 100 degrees. If the first direction is parallel to the second direction, the angle between the first direction and the second direction may be between 0 degrees and 10 degrees.

The electronic device described in the disclosure may be applied to a display device, a light emitting device, a backlight device, an antenna device, a sensing device, or a splicing device, or may be a temporary storage substrate used to assist electronic units to be placed at specific intervals. However, the disclosure is not limited thereto. The electronic device may be a bendable or flexible electronic device. The display device may be a non-self-luminous display device or a self-luminous display device. The antenna device may be a liquid crystal type antenna device or a non-liquid crystal type antenna device, and the sensing device may be a sensing device that senses capacitance, light, heat energy, or ultrasonic waves. However, the disclosure is not limited thereto. The electronic device may include electronic units such as passive devices and active devices, such as capacitors, resistors, inductors, diodes, transistors, etc. The diodes may include light emitting diodes or photodiodes. The light emitting diode (LED) may include, for example, organic light emitting diodes (OLED), mini light emitting diodes (mini LED), micro light emitting diodes (micro LEDs), or quantum dot light emitting diodes (quantum dot LED). However, the disclosure is not limited thereto. The splicing device may be, for example, a display splicing device or an antenna splicing device, but the disclosure is not limited thereto. It should be noted that the electronic device may be any combination of the above, but the disclosure is not limited thereto. In addition, a shape of the electronic device may be a rectangular shape, a circular shape, a polygonal shape, a shape with curved edges, or other suitable shapes.

FIG. 1A is a schematic partial cross-sectional view of a mirror electronic device according to the first embodiment of the disclosure.

Referring to FIG. 1A, in this embodiment, a mirror electronic device 10a includes a substrate SB1, a circuit layer CL, multiple electronic units EU, a substrate SB2, a reflective layer 100a, and an adhesive layer AL.

The substrate SB1 has, for example, a first surface SB1_S1 and a second surface SB1_S2 opposite to the first surface SB1_S1. In some embodiments, a material of the substrate SB1 may include glass, plastic, or a combination thereof. For example, the material of the substrate SB1 may include quartz, sapphire, silicon (Si), germanium (Ge), silicon carbide (SiC), gallium nitride (GaN), silicon germanium (SiGe), polymethyl methacrylate (PMMA), polycarbonate (PC), polyimide (PI), polyethylene terephthalate (PET), or other suitable materials or a combination of the above materials. In this embodiment, the material of the substrate SB1 is glass, but the disclosure is not limited thereto.

For example, the circuit layer CL is disposed on the first surface SB1_S1 of the substrate SB1. In some embodiments, the circuit layer CL may include multiple transistors (not shown), multiple wires (not shown), and multiple insulating layers (not shown), but the disclosure is not limited thereto.

The electronic units EU are, for example, disposed on the first surface SB1_S1 of the substrate SB1, and are, for example, electrically connected to the circuit layer CL. In some embodiments, the electronic units EU may be disposed on the substrate SB1 by performing mass transfer, but the disclosure is not limited thereto. Any one of the electronic units EU may, for example, emit light of various suitable colors (e.g., red light, green light, and blue light) or UV light, but the disclosure is not limited thereto. In some embodiments, the electronic units EU may include a self-luminous material. For example, in this embodiment, the electronic units EU may be light emitting diodes (LED), including, for example, organic light emitting diodes (OLED), micro light emitting diodes (micro LED), mini light emitting diodes (mini LED), quantum dot (QD) light emitting diodes, or a combination thereof, but the disclosure is not limited thereto. In some embodiments, the electronic units EU may include a red light emitting unit EU1, a green light emitting unit EU2, and a blue light emitting unit EU3. That is, the red light emitting unit EU1, the green light emitting unit EU2, and the blue light emitting unit EU3 may respectively emit the red light, the green light, and the blue light. However, the disclosure is not limited thereto. In other embodiments, each of the electronic units EU may emit the blue light or ultraviolet light.

The substrate SB2 has, for example, a first surface SB2_S1 and a second surface SB2_S2 opposite to the first surface SB2_S1. In this embodiment, the substrate SB2 is opposite to the substrate SB1. In detail, the first surface SB2_S1 of the substrate SB2 faces the first surface SB1_S1 of the substrate SB1. In this embodiment, the substrate SB2 includes a light-transmitting region R1 and a light-reflecting region R2. The light-transmitting region R1 is, for example, adjacent to the light-reflecting region R2, and the light-transmitting region R1 overlaps the electronic units EU. Descriptions of the light-transmitting region R1 and the light-reflecting region R2 will be described in detail in the following embodiments. Therefore, the same details will not be repeated in the following.

A material of the substrate SB2 may be the same as or similar to the material of the substrate SB1. Therefore, for the rest of the technical content of the substrate SB2, reference may be made to the description of the substrate SB1 in the foregoing embodiment. Therefore, the same details will not be repeated in the following.

The reflective layer 100a is, for example, disposed on a side of the substrate SB1 adjacent to the substrate SB2, and is located, for example, in the light-reflecting region R2. In this embodiment, the reflective layer 100a is disposed on the first surface SB1_S1 of the substrate SB1, and is disposed between the adjacent electronic units EU. In detail, the reflective layer 100a may be used, for example, to define the light-transmitting region R1 and the light-reflecting region R2 of the substrate SB2. The light-transmitting region R1 is a region where the reflective layer 100a is not disposed, and the light-reflecting region R2 is a region where the reflective layer 100a is disposed. From another perspective, the light-transmitting region R1 of the substrate SB2 overlaps the electronic units EU in a top-view direction z of the mirror electronic device 10a, and the light-reflecting region R2 of the substrate SB2 does not overlap the electronic units EU in the top-view direction z of the mirror electronic device 10a. In this embodiment, a material of the reflective layer 100a includes a metal material with high reflectivity. For example, the material of the reflective layer 100a may include aluminum (Al), molybdenum (Mo), chromium (Cr), silver (Ag), iron (Fe), gold (Au), nickel (Ni), and other suitable metal materials or an alloy of the above materials, and the disclosure is not limited thereto. In some embodiments, the reflective layer 100a includes a single metal layer or a stack of multiple different metal layers. For example, the reflective layer 100a may be a stack of silver and aluminum, but the disclosure is not limited thereto.

For example, the adhesive layer AL is disposed between the substrate SB1 and the substrate SB2, so that the substrate SB1 and the substrate SB2 are adhered to each other. The adhesive layer AL may, for example, include an optical clear resin (OCR) or an optical clear adhesive (OCA). For example, a material of the adhesive layer AL may include an acrylic resin, a silicone resin, an epoxy resin, or other suitable materials or a combination of the above materials, but the disclosure is not limited thereto. In other embodiments, the mirror electronic device 10a may not include the adhesive layer AL. That is, an air gap is included between the substrate SB1 and the substrate SB2.

In this embodiment, the mirror electronic device 10a further includes a passivation layer PAS. For example, the passivation layer PAS is disposed between the reflective layer 100a and the circuit layer CL in the top-view direction z of the mirror electronic device 10a, so that the reflective layer 100a and the circuit layer CL may be electrically insulated. In some embodiments, a material of the passivation layer PAS may include inorganic materials (e.g., silicon oxide, silicon nitride, silicon oxynitride, or a stacked layer of at least two of the above materials), but the disclosure is not limited thereto.

Based on the above, in this embodiment, in the top-view direction z of the mirror electronic device 10a, the light-transmitting region R1 of the substrate SB2 overlaps the electronic units EU, and the light-reflecting region R2 of the substrate SB2 does not overlap the electronic units EU. Through the above design, reflectivity of the mirror electronic device 10a may be improved, and a possibility of affecting the light emitted by the electronic units EU may be reduced, thereby increasing light emitting efficiency of the mirror electronic device 10a in this embodiment.

FIG. 1B is a schematic partial cross-sectional view of a mirror electronic device according to the second embodiment of the disclosure. It is noted that some of the reference numerals and descriptions in FIG. 1A may apply to FIG. 1B. The same or similar reference numerals will represent the same or similar components, and the descriptions of the same technical contents will be omitted.

Referring to FIG. 1B, a main difference between a mirror electronic device 10b in this embodiment and the mirror electronic device 10a is that a material of a reflective layer 100b includes a stack of multiple high refractive layers and low refractive layers.

In detail, in this embodiment, the reflective layer 100b may be a laminating body. The laminating body may include, for example, the high refractive layers (not shown) and the low refractive layers (not shown) that are alternately stacked. In some embodiments, a total number of the high refractive index layers and the low refractive index layers may be greater than or equal to 6. For example, the reflective layer 100b may include six film layers with the high refractive layers and the low refractive layers that are alternately stacked, or the reflective layer 100b may include, for example, ten film layers with the high refractive layers and the low refractive layers that are alternately stacked. The disclosure is not limited thereto. In some embodiments, the high refractive layer may, for example, has refractivity between 2.0 and 2.5, which may include silicon nitride (SiNₓ), niobium oxide (Nb₂O₅), titanium oxide (TiO₂), tantalum oxide (Ta₂O₅), or other suitable materials. The low refractive layer may, for example, has refractivity between 1.0 and 1.5, which may include silicon dioxide (SiO₂), magnesium fluoride (MgF₂), calcium fluoride (CaF₂), or other suitable materials. In some embodiments, a thickness of one single high refractive layer or low refractive layer may range from 10 nm to 500 nm, but the disclosure is not limited thereto.

FIG. 1C is a schematic partial cross-sectional view of a mirror electronic device according to the third embodiment of the disclosure. It is noted that some of the reference numerals and descriptions in FIG. 1A may apply to FIG. 1C. The same or similar reference numerals will represent the same or similar components, and the descriptions of the same technical contents will be omitted.

Referring to FIG. 1C, a main difference between a mirror electronic device 10c in this embodiment and the mirror electronic device 10a is that a reflective layer 100c is disposed on the first surface SB2_S1 of the substrate SB2.

FIG. 1D is a schematic partial cross-sectional view of a mirror electronic device according to the fourth embodiment of the disclosure. It is noted that some of the reference numerals and descriptions in FIG. 1C may apply to FIG. 1D. The same or similar reference numerals will represent the same or similar components, and the descriptions of the same technical contents will be omitted.

Referring to FIG. 1D, a main difference between a mirror electronic device 10d in this embodiment and the mirror electronic device 10c is that the mirror electronic device 10d further includes a light-absorbing layer 200a.

The light-absorbing layer 200a is, for example, disposed on the substrate SB1, and is, for example, located between the adjacent electronic units EU. In this embodiment, the light-absorbing layer 200a overlaps the reflective layer 100c in the top-view direction z of the mirror electronic device 10d. Through the configuration of the light-absorbing layer 200a, a phenomenon of optical crosstalk caused by the light emitted by the adjacent electronic units EU may be reduced. The light-absorbing layer 200a may, for example, include a suitable light-shielding material. For example, a material of the light-absorbing layer 200a may include a black resin or a metal material with low reflectivity, but the disclosure is not limited thereto.

FIG. 1E is a schematic partial cross-sectional view of a mirror electronic device according to the fifth embodiment of the disclosure. It is noted that some of the reference numerals and descriptions in FIG. 1C may apply to FIG. 1E. The same or similar reference numerals will represent the same or similar components, and the descriptions of the same technical contents will be omitted.

Referring to FIG. 1E, a main difference between a mirror electronic device 10e in this embodiment and the mirror electronic device 10c is that the mirror electronic device 10e further includes a light-absorbing layer 200b.

The light-absorbing layer 200b is, for example, disposed on the substrate SB2, and is located, for example, in the light-reflecting region R2 of the substrate SB2. In this embodiment, the light-absorbing layer 200b is directly disposed on a side of the reflective layer 100c away from the substrate SB2, and overlaps the reflective layer 100c in the top-view direction z of the mirror electronic device 10e. Through the configuration of the light-absorbing layer 200b, the phenomenon of optical crosstalk caused by the light emitted by the adjacent electronic units EU may be reduced. The light-absorbing layer 200b may, for example, include a suitable light-shielding material. For example, a material of the light-absorbing layer 200b may include the black resin or the metal material with low reflectivity, but the disclosure is not limited thereto.

A width W1 of the light-absorbing layer 200b in a direction x is, for example, less than or equal to a width W2 of the reflective layer 100c in the direction x, so as to reduce a possibility that the light-absorbing layer 200b affects the light emitted by the electronic units EU. In this embodiment, in the direction x of a cross-sectional view of the mirror electronic device 10e, the width W1 of the light-absorbing layer 200b is less than or equal to the width W2 of the reflective layer 100c, and the width W1 of the light-absorbing layer 200b is greater than or equal to 50% of the width W2 of the reflective layer 100c. However, the disclosure is not limited thereto. In some embodiments, a distance between a single side edge of the light-absorbing layer 200b and a corresponding side edge of the reflective layer 100c in the direction x is between 1 µm and 5 µm, but the disclosure is not limited thereto.

FIG. 1F is a schematic partial cross-sectional view of a mirror electronic device according to the sixth embodiment of the disclosure. It is noted that some of the reference numerals and descriptions in FIG. 1C to FIG. 1E may apply to FIG. 1F. The same or similar reference numerals will represent the same or similar components, and the descriptions of the same technical contents will be omitted.

Referring to FIG. 1F, a main difference between a mirror electronic device 10f in this embodiment and the mirror electronic device 10c is that the mirror electronic device 10f further includes both the light-absorbing layer 200a and the light-absorbing layer 200b. Regarding the technical contents of the light-absorbing layer 200a and the light-absorbing layer 200b, reference may be made to the foregoing embodiments. Therefore, the same details will not be repeated in the following.

FIG. 1G is a schematic partial cross-sectional view of a mirror electronic device according to the seventh embodiment of the disclosure. It is noted that some of the reference numerals and descriptions in FIG. 1C may apply to FIG. 1G. The same or similar reference numerals will represent the same or similar components, and the descriptions of the same technical contents will be omitted.

Referring to FIG. 1G, a main difference between a mirror electronic device 10g in this embodiment and the mirror electronic device 10c is that the mirror electronic device 10g further includes a color filter layer CF.

In this embodiment, the color filter layer CF is disposed on a side of the substrate SB2 adjacent to the substrate SB1, and is located in the light-transmitting region R1 of the substrate SB2. That is, the color filter layer CF is disposed on the first surface SB2_S1 of the substrate SB2, and is located between the adjacent reflective layers 100c. The color filter layer CF includes, for example, multiple filter units, and the filter units overlap the corresponding electronic units EU on the first surface SB2_S1 of the substrate SB2. In detail, in this embodiment, the color filter layer CF may include a red filter unit CF1, a green filter unit CF2, and a blue filter unit CF3, which respectively overlap the red light emitting unit EU1, the green light emitting unit EU2, and the blue light emitting unit EU3 in the top-view direction z of the mirror electronic device 10g. Through the configuration of the color filter layer CF, ambient light irradiated to the mirror electronic device 10g may be further absorbed, thereby improving a contrast ratio of the ambient light of the mirror electronic device 10g.

FIG. 1H is a schematic partial cross-sectional view of a mirror electronic device according to the eighth embodiment of the disclosure. It is noted that some of the reference numerals and descriptions in FIG. 1G and FIG. 1D may apply to FIG. 1H. The same or similar reference numerals will represent the same or similar components, and the descriptions of the same technical contents will be omitted.

Referring to FIG. 1H, a main difference between a mirror electronic device 10h in this embodiment and the mirror electronic device 10g is that the mirror electronic device 10h further includes the light-absorbing layer 200a. Regarding the technical content of the light-absorbing layer 200a, reference may be made to the foregoing embodiment. Therefore, the same details will not be repeated in the following.

FIG. 1I is a schematic partial cross-sectional view of a mirror electronic device according to the ninth embodiment of the disclosure. It is noted that some of the reference numerals and descriptions in FIG. 1G and FIG. 1E may apply to FIG. 1I. The same or similar reference numerals will represent the same or similar components, and the descriptions of the same technical contents will be omitted.

Referring to FIG. 1I, a main difference between a mirror electronic device 10i in this embodiment and the mirror electronic device 10g is that the mirror electronic device 10i further includes the light-absorbing layer 200b. Regarding the technical content of the light-absorbing layer 200b, reference may be made to the foregoing embodiment. Therefore, the same details will not be repeated in the following.

FIG. 1J is a schematic partial cross-sectional view of a mirror electronic device according to the tenth embodiment of the disclosure. It is noted that some of the reference numerals and descriptions in FIG. 1G and FIG. 1F may apply to FIG. 1J. The same or similar reference numerals will represent the same or similar components, and the descriptions of the same technical contents will be omitted.

Referring to FIG. 1J, a main difference between a mirror electronic device 10j in this embodiment and the mirror electronic device 10g is that the mirror electronic device 10j further includes both the light-absorbing layer 200a and the light-absorbing layer 200b. Regarding the technical contents of the light-absorbing layer 200a and the light-absorbing layer 200b, reference may be made to the foregoing embodiment. Therefore, the same details will not be repeated in the following.

FIG. 1K is a schematic partial cross-sectional view of a mirror electronic device according to the eleventh embodiment of the disclosure. It is noted that some of the reference numerals and descriptions in FIG. 1C may apply to FIG. 1K. The same or similar reference numerals will represent the same or similar components, and the descriptions of the same technical contents will be omitted.

Referring to FIG. 1K, a main difference between a mirror electronic device 10k in this embodiment and the mirror electronic device 10c is that the mirror electronic device 10k further includes an adhesion layer AD1 and an adhesion layer AD2.

The adhesion layer AD1 and the adhesion layer AD2 are, for example, disposed on the side of the substrate SB2 adjacent to the substrate SB1. In this embodiment, the adhesion layer AD1 and the adhesion layer AD2 form a laminating body with the reflective layer 100c in the top-view direction z of the mirror electronic device 10k, for example. In detail, the adhesion layer AD1 is disposed between the reflective layer 100c and the substrate SB2, and the adhesion layer AD2 is disposed between the reflective layer 100c and the substrate SB1. The reflective layer 100c may be disposed on the substrate SB2 through the adhesion layer AD1, for example, and may be used to buffer the reflective layer 100c and the substrate SB2. In some embodiments, materials of the adhesion layer AD1 and the adhesion layer AD2 may include transparent conductive oxide. For example, the materials of the adhesion layer AD1 and the adhesion layer AD2 may include indium tin oxide (ITO), indium zinc oxide (IZO), indium gallium oxide (IGO), or other suitable transparent conductive oxide, but the disclosure is not limited thereto. In addition, in some embodiments, the adhesion layer AD2 in FIG. 1K may be omitted depending on requirements or design requirements.

FIG. 1L is a schematic partial cross-sectional view of a mirror electronic device according to the twelfth embodiment of the disclosure. It is noted that some of the reference numerals and descriptions in FIG. 1K and FIG. 1I may apply to FIG. 1L. The same or similar reference numerals will represent the same or similar components, and the descriptions of the same technical contents will be omitted.

Referring to FIG. 1L, a main difference between a mirror electronic device 101 in this embodiment and the mirror electronic device 10k is that the mirror electronic device 101 further includes the light-absorbing layer 200b. The adhesion layer AD2 is disposed between the reflective layer 100c and the light-absorbing layer 200b, so that the light-absorbing layer 200b may be disposed on the reflective layer 100c through the adhesion layer AD2, for example. Regarding the technical content of the light-absorbing layer 200b, reference may be made to the foregoing embodiment. Therefore, the same details will not be repeated in the following.

FIG. 1M is a schematic partial cross-sectional view of a mirror electronic device according to the thirteenth embodiment of the disclosure. It is noted that some of the reference numerals and descriptions in FIG. 1K and FIG. 1H may apply to FIG. 1M. The same or similar reference numerals will represent the same or similar components, and the descriptions of the same technical contents will be omitted.

Referring to FIG. 1M, a main difference between a mirror electronic device 10m in this embodiment and the mirror electronic device 10k is that the mirror electronic device 10m further includes the light-absorbing layer 200a. Regarding the technical content of the light-absorbing layer 200a, reference may be made to the foregoing embodiment. Therefore, the same details will not be repeated in the following. In addition, in some embodiments, the adhesion layer AD2 in FIG. 1M may be omitted depending on the requirements or design requirements.

FIG. 1N is a schematic partial cross-sectional view of a mirror electronic device according to the fourteenth embodiment of the disclosure. It is noted that some of the reference numerals and descriptions in FIG. 1K and FIG. 1J may apply to FIG. 1N. The same or similar reference numerals will represent the same or similar components, and the descriptions of the same technical contents will be omitted.

Referring to FIG. 1N, a main difference between a mirror electronic device 10n in this embodiment and the mirror electronic device 10k is that the mirror electronic device 10n further includes both the light-absorbing layer 200a and the light-absorbing layer 200b. Regarding the technical contents of the light-absorbing layer 200a and the light-absorbing layer 200b, reference may be made to the foregoing embodiment. Therefore, the same details will not be repeated in the following.

FIG. 1O is a schematic partial cross-sectional view of a mirror electronic device according to the fifteenth embodiment of the disclosure. It is noted that some of the reference numerals and descriptions in FIG. 1K and FIG. 1G may apply to FIG. 1O. The same or similar reference numerals will represent the same or similar components, and the descriptions of the same technical contents will be omitted.

Referring to FIG. 1O, a main difference between a mirror electronic device 10o in this embodiment and the mirror electronic device 10k is that the mirror electronic device 10o further includes the color filter layer CF. Regarding the technical content of the color filter layer CF, reference may be made to the foregoing embodiment. Therefore, the same details will not be repeated in the following. In addition, in some embodiments, the adhesion layer AD2 in FIG. 1O may be omitted depending on the requirements or design requirements.

FIG. 1P is a schematic partial cross-sectional view of a mirror electronic device according to the sixteenth embodiment of the disclosure. It is noted that some of the reference numerals and descriptions in FIG. 1L and FIG. 1G may apply to FIG. 1P. The same or similar reference numerals will represent the same or similar components, and the descriptions of the same technical contents will be omitted.

Referring to FIG. 1P, a main difference between a mirror electronic device 10p in this embodiment and the mirror electronic device 101 is that the mirror electronic device 10p further includes the color filter layer CF. Regarding the technical content of the color filter layer CF, reference may be made to the foregoing embodiment. Therefore, the same details will not be repeated in the following.

FIG. 1Q is a schematic partial cross-sectional view of a mirror electronic device according to the seventeenth embodiment of the disclosure. It is noted that some of the reference numerals and descriptions in FIG. 1M and FIG. 1G may apply to FIG. 1Q. The same or similar reference numerals will represent the same or similar components, and the descriptions of the same technical contents will be omitted.

Referring to FIG. 1Q, a main difference between a mirror electronic device 10q in this embodiment and the mirror electronic device 10m is that the mirror electronic device 10q further includes the color filter layer CF. Regarding the technical content of the color filter layer CF, reference may be made to the foregoing embodiment. Therefore, the same details will not be repeated in the following. In addition, in some embodiments, the adhesion layer AD2 in FIG. 1Q may be omitted depending on the requirements or design requirements.

FIG. 1R is a schematic partial cross-sectional view of a mirror electronic device according to the eighteenth embodiment of the disclosure. It is noted that some of the reference numerals and descriptions in FIG. 1N and FIG. 1G may apply to FIG. 1R. The same or similar reference numerals will represent the same or similar components, and the descriptions of the same technical contents will be omitted.

Referring to FIG. 1R, a main difference between a mirror electronic device 10r in this embodiment and the mirror electronic device 10n is that the mirror electronic device 10r further includes the color filter layer CF. Regarding the technical content of the color filter layer CF, reference may be made to the foregoing embodiment. Therefore, the same details will not be repeated in the following.

FIG. 1S is a schematic partial cross-sectional view of a mirror electronic device according to the nineteenth embodiment of the disclosure. It is noted that some of the reference numerals and descriptions in FIG. 1G may apply to FIG. 1S. The same or similar reference numerals will represent the same or similar components, and the descriptions of the same technical contents will be omitted.

Referring to FIG. 1S, a main difference between a mirror electronic device 10s in this embodiment and the mirror electronic device 10g is that the mirror electronic device 10s further includes a pixel definition layer PDL, a light conversion layer LS, a scattering layer SC, and a barrier layer BANK.

The pixel definition layer PDL is, for example, disposed on a side of the circuit layer CL away from the substrate SB1, and is disposed between the adjacent electronic units EU. In some embodiments, the pixel definition layer PDL may be used to define a configuration position in each of the electronic units EU, but the disclosure is not limited thereto. The pixel definition layer PDL may include, for example, a transparent material, a light-shielding material, or a reflective material. For example, a material of the pixel definition layer PDL may include transparent organic photoresist, white organic photoresist, or black organic photoresist, but the disclosure is not limited thereto.

The light conversion layer LS is, for example, disposed on a side of the color filter layer CF away from the substrate SB2, and includes, for example, a light conversion layer LS1 and a light conversion layer LS2. In addition, in this embodiment, each of the electronic units EU is a light emitting unit that emits the light of the same color. For example, each of the electronic units EU is the blue light emitting unit EU3, but the disclosure is not limited thereto.

For example, the light conversion layer LS1 and the light conversion layer LS2 overlap the corresponding filter units in the top-view direction z of the mirror electronic device 10s, and each overlap the corresponding electronic units. In detail, in this embodiment, the light conversion layer LS1 overlaps the red filter unit CF1 and the corresponding blue light emitting unit EU3 in the top-view direction z of the mirror electronic device 10s, and the light conversion layer LS2 overlaps with the green filter unit CF2 and the corresponding blue light emitting unit EU3 in the top-view direction z of the mirror electronic device 10s. In some embodiments, materials of the light conversion layer LS1 and the light conversion layer LS2 may each include quantum dot materials, phosphorescent materials, fluorescent materials, other suitable wavelength conversion materials, or combinations thereof. In other words, the light conversion layer LS1 and the light conversion layer LS2 may each convert the blue light emitted by the blue light emitting unit EU3 into light with another wavelength. In this embodiment, a color of the light with another wavelength converted by each of the light conversion layer LS1 and the light conversion layer LS2 may roughly correspond to colors of the red filter unit CF1 and the green filter unit CF2.

The scattering layer SC is also, for example, disposed on the side of the color filter layer CF away from the substrate SB2, and overlaps the corresponding filter unit and electronic unit, for example. In this embodiment, the scattering layer SC overlaps the blue filter unit CF3 and the corresponding blue light emitting unit EU3 in the top-view direction z of the mirror electronic device 10s. In some embodiments, the scattering layer SC may include an organic material and titanium dioxide particles located therein to scatter the blue light emitted by the blue light emitting unit EU3, but the disclosure is not limited thereto.

For example, the barrier layer BANK is disposed on the side of the reflective layer 100c away from the substrate SB2. In some embodiments, the barrier layer BANK may be used to define configuration positions of the light conversion layer LS1, the light conversion layer LS2, and the scattering layer SC, but the disclosure is not limited thereto. In addition, the barrier layer BANK overlaps the corresponding reflective layer 100c in the top-view direction z of the mirror electronic device 10s, for example. In this embodiment, the reflective layer 100c is disposed between the barrier layer BANK and the substrate SB2. The barrier layer BANK may, for example, include suitable organic materials or inorganic materials, and the disclosure is not limited thereto.

FIG. 1T is a schematic partial cross-sectional view of a mirror electronic device according to the twentieth embodiment of the disclosure. It is noted that some of the reference numerals and descriptions in FIG. 1S and FIG. 1I may apply to FIG. 1T. The same or similar reference numerals will represent the same or similar components, and the descriptions of the same technical contents will be omitted.

Referring to FIG. 1T, a main difference between a mirror electronic device 10t in this embodiment and the mirror electronic device 10s is that the mirror electronic device 10t further includes the light-absorbing layer 200b, and the light-absorbing layer 200b is disposed between the reflective layer 100c and the barrier layer BANK in the top-view direction z of the mirror electronic device 10t. Regarding the technical content of the light-absorbing layer 200b, reference may be made to the foregoing embodiment. Therefore, the same details will not be repeated in the following.

FIG. 1U is a schematic partial cross-sectional view of a mirror electronic device according to the twenty-first embodiment of the disclosure. It is noted that some of the reference numerals and descriptions in FIG. 1S and FIG. 1B may apply to FIG. 1U. The same or similar reference numerals will represent the same or similar components, and the descriptions of the same technical contents will be omitted.

Referring to FIG. 1U, a main difference between a mirror electronic device 10u in this embodiment and the mirror electronic device 10s is that the mirror electronic device 10u includes the reflective layer 100b but does not include the reflective layer 100c, and the material of the reflective layer 100b includes the stack of multiple high refractive layers and low refractive layers. Regarding the technical content of the reflective layer 100b, reference may be made to the foregoing embodiment. Therefore, the same details will not be repeated in the following.

FIG. 1V is a schematic partial cross-sectional view of a mirror electronic device according to the twenty-second embodiment of the disclosure. It is noted that some of the reference numerals and descriptions in FIG. 1U and FIG. 1I may apply to FIG. 1V. The same or similar reference numerals will represent the same or similar components, and the descriptions of the same technical contents will be omitted.

Referring to FIG. 1V, a main difference between a mirror electronic device 10v in this embodiment and the mirror electronic device 10u is that the mirror electronic device 10v further includes the light-absorbing layer 200b, and the light-absorbing layer 200b is disposed between the reflective layer 100b and the barrier layer BANK in the top-view direction z of the mirror electronic device 10v. Regarding the technical content of the light-absorbing layer 200b, reference may be made to the foregoing embodiment. Therefore, the same details will not be repeated in the following.

Based on the above, the mirror electronic device in some embodiments of the disclosure includes the light-transmitting region and the light-reflecting region defined through the configuration of the reflective layer. In the top-view direction of the mirror electronic device, the light-transmitting region overlaps the electronic units, and the light-reflecting region does not overlap the electronic units. Through the above design, when the mirror electronic device in some embodiments of the disclosure is applied to a vehicle electronic device, the reflectivity of the mirror electronic device that is not in the turned-on state may be increased to facilitate a user to observe the surrounding environment at a rear and/or sides of a vehicle. In addition, through the configuration of the reflective layer, the possibility of affecting the light emitted by the electronic units in the mirror electronic device may be reduced, thereby increasing the light emitting efficiency of the mirror electronic device when it is in the turned-on state to improve quality of a display image thereof.

Furthermore, the mirror electronic device in some embodiments of the disclosure further includes the light-absorbing layer disposed on a side of the reflective layer away from the substrate, and the width of the light-absorbing layer is designed to be less than or equal to the width of the reflective layer and greater than or equal to 50% of the width of the reflective layer. Through the configuration of the light-absorbing layer, since the light-absorbing layer does not overlap the light-transmitting region in the top-view direction of the mirror electronic device, it may reduce the phenomenon of optical crosstalk caused by the light emitted by the adjacent electronic units in the mirror electronic device according to some embodiments of the disclosure, so as to further improve the quality of the display image when the mirror electronic device is in the turned-on state.

## Claims

1. A mirror electronic device (10e, 10f, 10i, 10j, 101, 10n, 10p, 10r, 10t, 10v), comprising:
a first substrate (SB1);
a circuit layer (CL) disposed on the first substrate;
a plurality of electronic units (EU) disposed on the first substrate and electrically connected to the circuit layer;
a second substrate (SB2) opposite to the first substrate, and comprising a light-transmitting region (R1) and a light-reflecting region (R2), wherein the light-transmitting region is adjacent to the light-reflecting region, and the light-transmitting region overlaps the electronic units;
a reflective layer (100a, 100b, 100c) disposed on a side of the second substrate adjacent to the first substrate and located in the light-reflecting region;
a first light-absorbing layer (200b) disposed on a side of the reflective layer away from the second substrate; and
an adhesive layer (AL) disposed between the first light-absorbing layer and the electronic units,
wherein in a cross-sectional view of the mirror electronic device, a width (W1) of the first light-absorbing layer is less than or equal to a width (W2) of the reflective layer, and the width of the first light-absorbing layer is greater than or equal to 50% of the width of the reflective layer.

2. The mirror electronic device according to claim 1, wherein the first light-absorbing layer is directly disposed on the side of the reflective layer away from the second substrate.

3. The mirror electronic device according to claim 1, further comprising:
a second light-absorbing layer (200a) disposed on the circuit layer and located between the two adjacent electronic units.

4. The mirror electronic device according to claim 1, wherein the reflective layer comprises a single metal layer or a stack of a plurality of different metal layers.

5. The mirror electronic device according to claim 1, wherein the reflective layer comprises a stack of a plurality of high refractive layers and low refractive layers.

6. The mirror electronic device according to claim 1, further comprising:
a color filter layer (CF) disposed on the side of the second substrate adjacent to the first substrate and located in the light-transmitting region.

7. The mirror electronic device according to claim 6, further comprising:
a light conversion layer (LS) disposed on a side of the color filter layer away from the second substrate.

8. The mirror electronic device according to claim 6, further comprising:
a scattering layer (CC) disposed on a side of the color filter layer away from the second substrate.

9. The mirror electronic device according to claim 7, further comprising:
a barrier layer (BANK) disposed on the side of the color filter layer away from the second substrate, wherein the barrier layer overlaps the reflective layer in a top-view direction (z) of the mirror electronic device.

10. The mirror electronic device according to claim 1, further comprising:
a first adhesion layer (AD1) disposed on the side of the second substrate adjacent to the first substrate and located between the reflective layer and the second substrate; and
a second adhesion layer (AD2) disposed on the side of the second substrate adjacent to the first substrate and located between the reflective layer and the first light-absorbing layer.

11. The mirror electronic device according to claim 10, wherein materials of the first adhesion layer and the second adhesion layer comprise transparent conductive oxide.

12. The mirror electronic device according to claim 1, further comprising:
an adhesion layer (AL) disposed on the side of the second substrate adjacent to the first substrate and located between the reflective layer and the second substrate.

13. The mirror electronic device according to claim 12, wherein a material of the adhesion layer comprises transparent conductive oxide.

14. The mirror electronic device according to claim 1, wherein in the cross-sectional view of the mirror electronic device, a distance between a single side edge of the first light-absorbing layer and a corresponding side edge of the reflective layer is between 1 µm and 5 µm.

15. The mirror electronic device according to claim 1, wherein an air gap is comprised between the first substrate and the second substrate.
